# EUROPÄISCHE PATENTANMELDUNG

(11) **EP 0 774 667 A2**
(43) Veröffentlichungstag der Anmeldung: **21.05.1997**
(21) Anmeldenummer: 96117382.0
(22) Anmeldetag: 30.10.1996
(51) Int. Cl.: G01R 31/04

(54) **Überprufung des Verbindens zweier Teile**

(30) Priorität: 16.11.1995 DE 19542822; 17.01.1996 DE 19601562; 29.02.1996 DE 19607698
(71) Anmelder: THE WHITAKER CORPORATION, Wilmington, Delaware 19808 (US)
(72) Erfinder: Kourimsky, Friedrich Josef Alois, 64625 Bensheim (DE); Lietz, Dieter, 60388 Frankfurt (DE); Post, Lothar, 63067 Offenbach (DE); Kunze, Jörg, 65428 Rüsselsheim (DE); Neumeuer, Horst, 64732 Bad König (DE)
(74) Vertreter: Heinz-Schäfer, Marion

(57) **Zusammenfassung**

Die Anordnung zur elektrischen Überprüfung des Verbindens zweier Teile weist zwei Kontakte (1) auf, die jeweils einen Bereich zur Kontaktierung eines elektrischen Leiters, einen sich daran anschliessenden Zwischenbereich und einen sich an diesen anschliessenden Kontaktstift aufweisen. Der Kontaktstift (5) ist jeweils in Bezug auf den Zwischenbereich in axialer Richtung federnd verschiebbar. Es ist ein Gehäuse (11) vorgesehen, mit zwei parallelen Kontaktkammern (12) zur Aufnahme der Kontakte (1). Das Gehäuse ist am ersten zu verbindenden Teil (2) befestigbar. Am Gehäuse (11) ist eine federnd gelagerte Haube (13) vorgesehen, die in Bezug auf die Kontakte (1) in axialer Richtung verschiebbar ist. Die Haube (13) weist einen Boden (131) auf, der eine Metallbrücke (132) enthält, die die Kontakte (1) kurzschliesst, wenn die Haube (13) in eine entsprechende Stellung verschoben ist.

## Beschreibung

Die Erfindung betrifft eine Anordnung zur elektrischen Überprüfung des Verbindens zweier Teile, insbesondere zur elektrischen Überprüfung des Steckzustandes zweier Steckerhälften, eine Verwendung einer solchen Anordnung und eine Steckerhälfte, sowie einen Kontakt, der insbesondere in einer solchen Anordnung verwendet werden kann.

Heutzutage ist es in vielen Anwendungsfällen notwendig zu kontrollieren, ob ein Stecker tatsächlich vollständig gesteckt ist. Beispielsweise bei den Stirnwandsteckern von Automobilen, die an der Schnittstelle zwischen Motorenraum und Fahrgastraum angeordnet sind, muss die Kontaktierung sichergestellt sein, da durch diesen Stecker auch sicherheitsrelevante Leitungen verbunden werden. Geringe Toleranzen zwischen den beiden Steckerhälften können dabei von einer entsprechenden Anordnung aufgefangen werden. Um jedoch eine zuverlässige Aussage auch dann zu ermöglichen, wenn grössere Toleranzen auftreten ist es notwendig, eine Anordnung anzugeben, die solche Toleranzen auffängt.

Es ist Aufgabe der Erfindung eine Anordnung, eine Verwendung der Anordnung und einen Kontakt und eine Steckerhälfte für eine solche Anordnung anzugeben, mit der die Kontaktierung zweier Steckerhälften beziehungsweise das Verbinden zweier Teile elektrisch überprüft werden kann.

Die Aufgabe wird bezüglich der Anordnung durch eine Anordnung durch eine Anordnung mit den Merkmalen des Patentanspruches 1, bezüglich der Verwendung durch eine Verwendung gemäss Patentanspruch 6 und bezüglich der Kontakte durch Kontakte mit den Merkmalen des Patentanspruches 7 gelöst und bezüglich der Steckerhälfte, durch eine Steckerhälfte mit den Merkmalen des Anspruches 12 gelöst. Vorteilhafte Weiterbildungen sind jeweils in den Unteransprüchen angegeben.

Es ist besonders vorteilhaft, dass die Steckerhälfte derart ausgebildet ist, dass eine Kontaktierung auch dann hergestellt wird, wenn die beiden Steckerhälften grössere Toleranzen zueinander aufweisen.

Bestehen zwischen einer ersten und einer zweiten Steckerhälfte grössere Toleranzen und kann nur ein bestimmtes Mass an Toleranz ausgeglichen werden, so ist es notwendig, dass sich eine der Steckerhälften in der Lage an die zweite Steckerhälfte anpasst. Die erfindungsgemässe Steckerhälfte besteht aus zwei Gehäuseteilen, die zueinander beweglich sind und mittels komplementärer Mittel miteinander verrasten. Beim Zusammenfügen dieser Steckerhälfte mit einer komplementären Steckerhälfte wird das eine bewegliche Gehäuseteil derart verschoben, dass es sich optimal an die zweite Steckerhälfte anpasst. In dieser verschobenen Stellung verrastet das zweite Gehäuseteil mit dem ersten Gehäuseteil. Beim Entfernen der zweiten komplementären Steckerhälfte aus der ersten Steckerhälfte bleibt das bewegliche zweite Gehäuseteil in der Position, die es durch das Zusammenfügen der Stecker eingenommen hat. Eine besonders vorteilhafte Verwendung einer Steckerhälfte mit den Merkmalen des Patentanspruches besteht bei einer Anordnung zur elektrischen Überprüfung des Verbindens zweier Teile.

In der erfindungsgemässen Anordnung werden Kontakte eingesetzt, die jeweils einen Bereich zur Kontaktierung eines elektrischen Leiters, einen sich daran anschliessenden Zwischenbereich und einen sich an diesen anschliessenden Kontaktstift, der in Bezug auf den Zwischenbereich in longitudinaler Richtung federnd verschiebbar ist, aufweist. Durch eine solche Ausbildung der Kontakte ist gewährleistet, dass der Kontaktierungspunkt nicht an einem fest vorgegebenen Punkt sondern auf einer Linie liegt, die durch die Verschiebbarkeit des Kontaktstiftes vorgegeben ist. Zwei in einem Gehäuse angeordnete Kontakte werden durch das Anpressen einer Metallbrücke miteinander verbunden. Die Metallbrücke ist dabei Teil einer Haube, die ebenfalls federnd verschiebbar ist. Durch diese federnde Lagerung ist es möglich axiale Toleranzen auszugleichen und Pressungen in radialer Richtung zu vermeiden. Aufgrund der besonderen Ausgestaltung der Kontakte ist eine Verarbeitung dieser Kontakte wie eine Verarbeitung von nichtfedernden Kontakten möglich. Das Gehäuse zur Aufnahme der Kontakte kann beispielsweise derart ausgebildet sein, dass es an einer ersten zu verbindenden Steckerhälfte verrastet werden kann. Die federnd gelagerte Haube wird dann von der zweiten Steckerhälfte, wenn diese mit der ersten Steckerhälfte verbunden wird, gegen die Kontakte gedrückt. Dadurch entsteht ein Kurzschluss zwischen den Kontakten, die mit einem Überprüfungsstromkreis verbunden sind. Mittels dieses Überprüfungsstromkreises kann nun festgestellt werden, ob die beiden Steckerhälften vollständig gesteckt sind oder nicht.

Eine Verwendung der Anordnung in einer Öffnung der ersten Steckerhälfte für eine zentrale Hebeschraube ist besonders vorteilhaft, da dadurch das tatsächliche Eindringen der Hebeschraube überprüft werden kann. Es wird also nicht nur festgestellt, ob die beiden Stecker gesteckt sind, sondern auch ob die Hebeschraube fixiert ist. Eine grosse Veränderung an Steckerteilen, die eine Aufnahme für eine Hebeschraube aufweisen, muss nicht durchgeführt werden. Es genügt das Anbringen von zwei Rastnasen, um die Anordnung zur elektrischen Überprüfung der Kontaktierung an diesen zu verrasten.

Ausführungsbeispiele der Erfindung werden nun anhand der Zeichnungen erläutert. Es zeigen:
Figur 1 ein erstes Ausführungsbeispiel einer erfindungsgemässe Anordnung, die in einer Öffnung der ersten Steckerhälfte für eine zentrale Hebeschraube verrastet ist bei nicht eingebrachter Hebeschraube,
Figur 2 eine entsprechende Anordnung bei eingebrachter Hebeschraube,
Figur 3 eine Ansicht eines erfindungsgemässen elektrischen Kontaktes,
Figur 4 eine schematische Darstellung eines erfindungsgemässen Kontaktes, wenn dieser nicht kontaktiert ist,
Figur 5 eine schematische Darstellung eines erfindungsgemässen Kontaktes, wenn dieser kontaktiert ist,
Figur 6 ein zweites Ausführungsbeispiel einer erfindungsgemässe Anordnung im Anlieferzustand, die in einer Öffnung der ersten Steckerhälfte für eine zentrale Hebeschraube verrastet ist, und
Figur 7 und 7a eine entsprechende Steckerhälfte bei eingebrachter Hebeschraube.

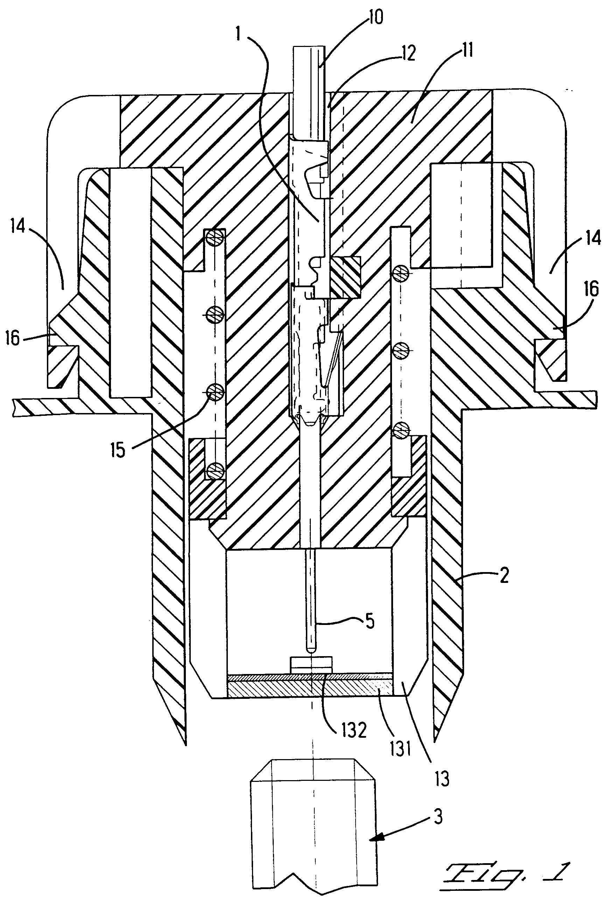

In den Figuren 1 und 2 ist ein erstes Ausführungsbeispiel einer erfindungsgemässen Anordnung in zwei verschiedenen Zuständen dargestellt. In Figur 1 sind die beiden zu verbindenden Teile, beispielsweise die beiden zu verbindenden Steckerhälften, noch nicht miteinander verbunden, während sie in Figur 2 miteinander verbunden sind. Es handelt sich in der beispielhaften Darstellung der Figuren 1 und 2 um zwei Stecker, die mittels einer zentrale Hebeschraube 3 miteinander verbunden werden. Entsprechend ist an der ersten zu verbindenden Steckerhälfte 2 eine Aufnahme für die zentrale Hebeschraube vorgesehen, in die die Anordnung zur Überprüfung der Kontaktierung eingebracht ist.

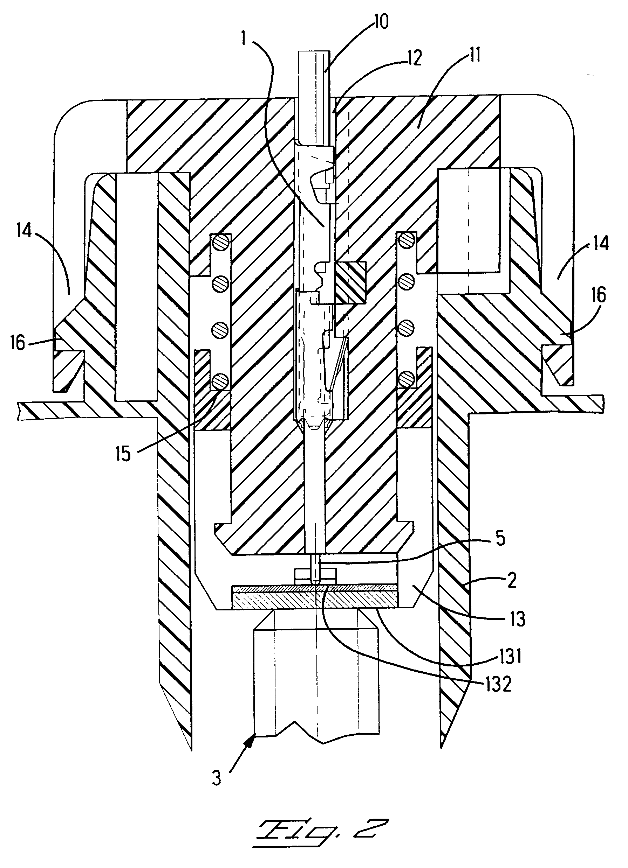

Es ist ein Gehäuse 11 vorgesehen, das Mittel zum Verrasten 14 aufweist, die mit entsprechenden Rastnasen 16 an der ersten Steckerhälfte 2 verrasten. Das Gehäuse 11 weist weiter zwei Kontaktkammern 12 auf, die in der gezeigten Darstellung senkrecht zur Papierebene hintereinander angeordnet sind. In jeder Kontaktkammer 12 befindet sich ein elektrischer
Kontakt 1. Auf die Kontakte 1 soll im Zusammenhang mit den Figuren 3 bis 5 näher eingegangen werden. Der Kontakt 1 weist einen Kontaktstift 5 auf, der aus dem Gehäuse 11 heraustritt. Der Kontaktstift 5 ist in axialer Richtung entgegen einer Federkraft verschiebbar. Am anderen Ende ist der Kontakt 1 mit einem elektrischen Leiter 10 verbunden. Dieser elektrische Leiter 10 führt beispielsweise zu einem Überprüfungsstromkreis. An dem Ende mit dem Kontaktstift 5 ist das Gehäuse 11 durch eine Haube 13 abgedeckt. Die
Haube 13 weist einen Boden 131 auf, der wiederum eine Metallbrücke 132 trägt. Die Haube 13 ist ebenfalls in axialer Richtung verschiebbar, wobei eine Feder 15 dafür sorgt, dass die Haube im nichtbelasteten Zustand von den Kontaktstiften 5 entfernt gehalten wird. Werden nun die beiden zu verbindenden Steckerhälften zusammengefügt, so übt die Hebeschraube 3 einen Druck auf die Haube 13 auf, diese wird in Richtung auf das Gehäuse 11 verschoben und berührt mit der Metallbrücke 132 die Kontaktstifte 5 der hintereinanderliegenden
Kontakte 1 und schliesst diese somit kurz. Da sowohl die Kontaktstifte als auch die Haube federnd ausgebildet sind, findet eine belastungsfreie Kontaktierung nicht nur an einen Punkt statt, sonder über einen weiten federnden Bereich. Dadurch ist es möglich axiale Toleranzen auszugleichen. Eine Belastung der Kontakte erfolgt nicht. Die Haube 13 ist durch diverse Anschläge am Gehäuse 11 unverlierbar befestigt.

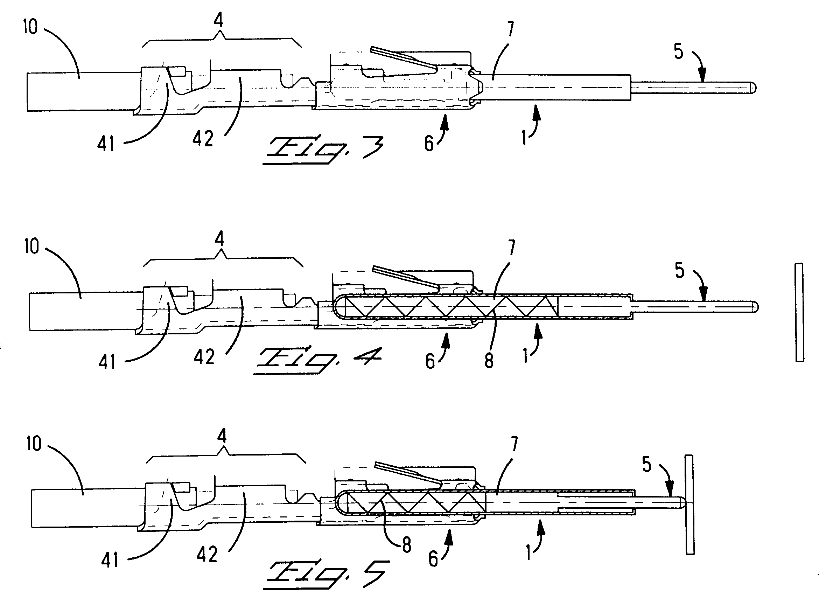

In den Figuren 3 bis 5 ist ein erfindungsgemässer Kontakt dargestellt. Der Kontakt weist jeweils einen Crimpbereich 4, einen Zwischenbereich 6 und einen Kontaktstift 5 auf. Der Crimpbereich 4 kann beispielsweise einen Isolationscrimp 41 und einen Leitercrimp 42 zur Kontaktierung mit einem elektrischen Leiter 10 aufweisen. Anstatt der Crimpanschlüsse ist es auch möglich den Bereich zur Kontaktierung mit einem elektrischen Leiter durch andere Kontaktierungsmittel auszubilden. Beispielsweise ist es möglich, auf dieser Seite des Kontaktes einen Buchsenkontakt vorzusehen, der dann wiederum mit einem anderen Stiftkontakt kontaktiert wird. Der Zwischenbereich 6 zeichnet sich nicht nur durch eine Verriegelungsblattfeder 9 aus, mit der der Kontakt in einem Gehäuse gehalten wird, sondern auch dadurch, dass in diesem Bereich ein Aussengehäuse 7 gehalten wird, in dem sich eine Feder 8 befindet, und ein Teil des Kontaktstiftes 5. Durch Druck auf den Kontaktstift 5 wird dieser in das Aussengehäuse 7 unter Komprimierung der Feder 8 eingeschoben. Dies ist in den Figuren 4 und 5 dargestellt.

Zur Wirkungsweise der Anordnung zur elektrischen Überprüfung zweier Stecker: In einem ersten Zustand, wenn die Stecker nicht miteinander oder nur unvollständig miteinander verbunden sind, sind die Federn sowohl zur Federung der Haube 13 als auch zur Federung des Kontaktstiftes 5 entspannt. Eine elektrische Verbindung der Kontaktstifte 5 der beiden Kontakte 1 liegen nicht vor. Wird nun durch Zusammenfügen der zu verbindenden Steckerhälften ein Druck auf die Haube 13 in axialer Richtung ausgeübt, so verschiebt sich diese Haube in Richtung auf die Kontaktstifte 5. Nach einer bestimmten Weglänge findet eine Kontaktierung der Kontaktstifte 5 durch die Metallbrücke 132 an der Haube 13 statt. An diesem Punkt zeigt also die Anordnung zur Überprüfung den Zustand gesteckt an und somit sollten die Stecker auch bereits gesteckt sein. Es ist jedoch möglich, dass aufgrund axialer Ungenauigkeiten eine weitere Verschiebung in axialer Richtung, dass heisst noch weiteres Zusammenstecken der Steckerhälfte möglich ist. Wenn es zu einem noch weiteren Zusammenstecken kommt, wird die Feder 8 in den Kontakten 1 belastet und komprimiert. Dadurch entsteht ein erhöhter Andruck der Kontaktstifte 5 gegen die Metallbrücke 132. Die Kontaktstifte 5 bleiben jedoch von äusseren Spannungen unbelastet. Somit ist es einfach möglich einen axialen Ausgleich vorzunehmen, ohne dadurch die Kontaktierung zu belasten oder zu gefährden.

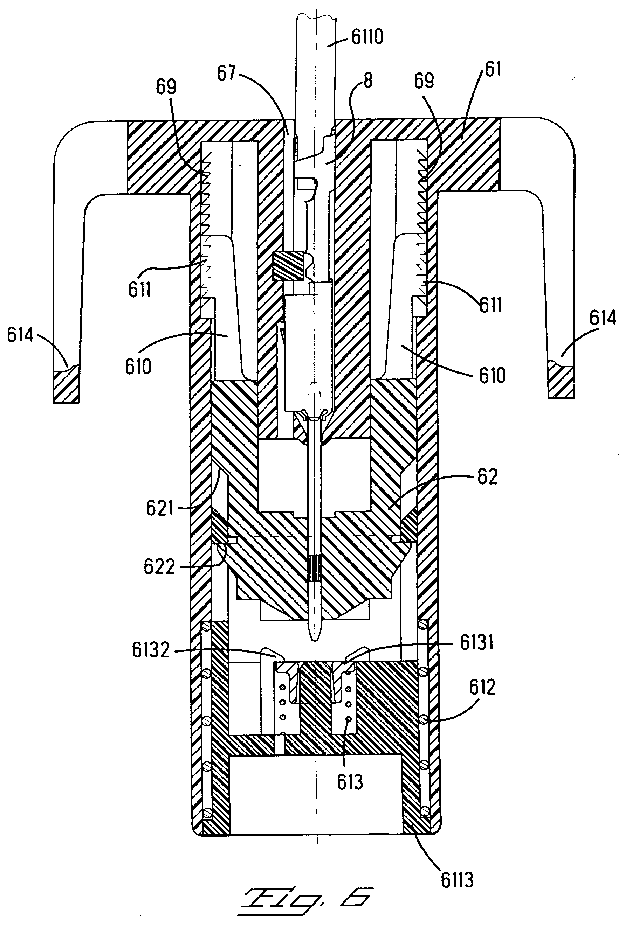

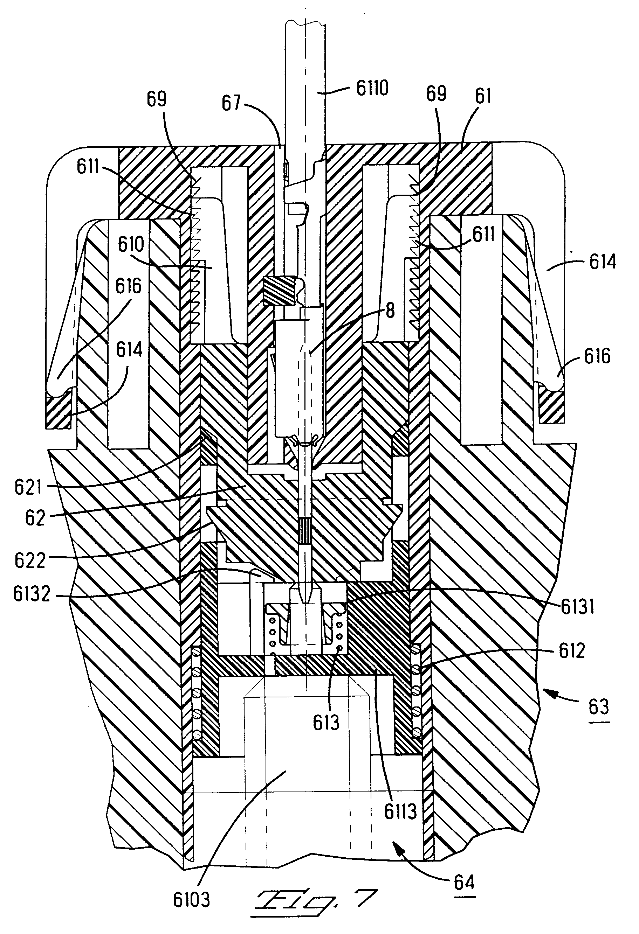

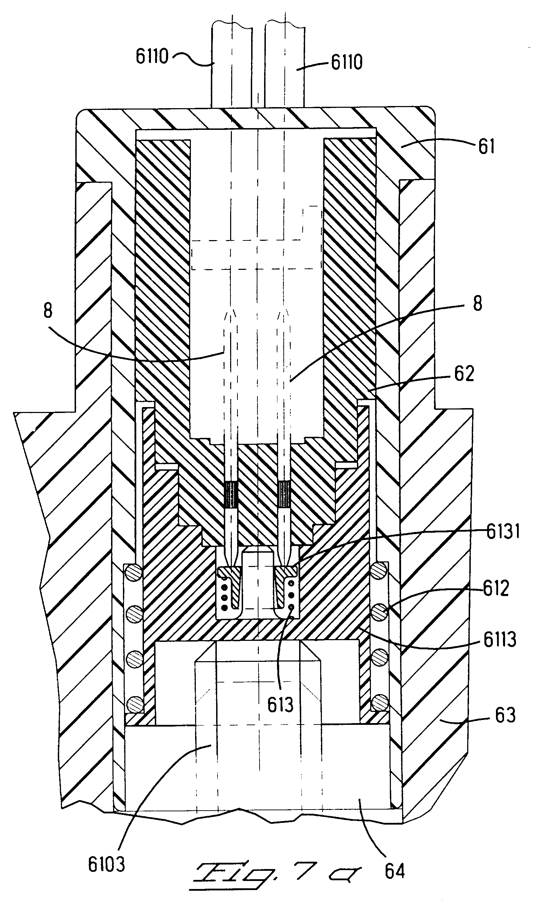

In den Figuren 6, 7 und 7a ist ein zweites Ausführungsbeispiel einer erfindungsgemässen Steckerhälfte in zwei verschiedenen Zuständen dargestellt. Bei der Anlieferung der ersten Steckerhälfte, das heisst bevor diese zum ersten Mal mit einer komplementären Steckerhälfte verbunden ist, befindet sich das zweite Gehäuseteil im Bezug auf das erste Gehäuseteil in der extremen Lage in Richtung auf die Seite hin, von der die komplementäre Steckerhälfte eingefügt wird. Beim Einfügen der komplementären Steckerhälfte verschiebt sich nun zunächst die Haube von ihrer durch die Federn bestimmten extremen Lage, in die durch den Anschlag am zweiten Gehäuseteil bestimmten extremen Lage und danach die Haube, und das zweite Gehäuseteil im ersten Gehäuseteil. Sind die beiden Steckerhälften vollständig miteinander verbunden, so bewegt sich das zweite Gehäuseteil nicht mehr weiter im ersten Gehäuseteil. Wird nun die zweite Steckerhälfte entnommen, so bewegt sich die Haube wieder zurück in ihre Anfangslage aber das zweite Gehäuseteil bleibt im ersten Gehäusteil in der fixierten zweiten Position. Beim erneuten Einfügen der komplementären Steckerhälfte verschiebt sich wiederum die Haube und aufgrund der federnden Lagerung der Haube des Stiftes und der Metallbrücke findet eine Kontaktierung auch dann statt, wenn die zweite Steckerhälfte nicht genauso weit eingebracht wird, wie bei dem ersten Mal. Geringere Toleranzen können also auch durch die Federungen abgefangen werden. Die grösseren Toleranzen werden jedoch durch die Verschiebung des zweiten Gehäuseteils im ersten Gehäuseteil aufgefangen.

In Figur 6 sind die beiden zu verbindenden Steckerhälften, noch nicht miteinander verbunden, während sie in Figur 7 miteinander verbunden sind. Es handelt sich in der beispielhaften Darstellung der Figuren 6, 7 und 7a um zwei Steckerhälften, die mittels einer zentrale Hebeschraube 6103 miteinander verbunden werden. Entsprechend ist an der ersten zu verbindenden Steckerhälfte 63 eine Aufnahme für die zentrale Hebeschraube 6103 vorgesehen, in die die Anordnung zur Überprüfung der Kontaktierung eingebracht ist. Es ist ein erstes Gehäuseteil 61 vorgesehen, das Mittel zum Verrasten 614 aufweist, die mit entsprechenden Rastnasen 16 an der ersten Steckerhälfte 63 verrasten. Das Gehäuseteil 61 weist weiter zwei Kontaktkammern 67 auf, die in der gezeigten Darstellung senkrecht zur Papierebene hintereinander angeordnet sind. In jeder Kontaktkammer 67 befindet sich ein elektrischer Kontakt 8. Auf die Kontakte 8 soll im Zusammenhang mit den Figuren 3 bis 5 näher eingegangen werden. Der Kontakt 8 weist einen Kontaktstift 5 auf, der aus dem Gehäuseteil 61 heraustritt. Der Kontaktstift 5 ist in axialer Richtung entgegen einer Federkraft verschiebbar. Am anderen Ende ist der Kontakt 8 mit einem elektrischen Leiter 10 verbunden. Dieser elektrische Leiter 10 führt beispielsweise zu einem Überprüfungsstromkreis. An dem Ende mit dem Kontaktstift 5 ist der Gehäuseteil 61 durch eine Haube 6113 abgedeckt. Die Haube 6113 weist einen Boden 6131 auf, der wiederum eine Metallbrücke trägt und gegenüber der Haube 6113 federnd gelagert ist durch die Feder 613. Die Haube 6113 ist ebenfalls in axialer Richtung verschiebbar, wobei eine Feder 612 dafür sorgt, dass die Haube im nichtbelasteten Zustand von den Kontaktstiften 5 entfernt gehalten wird. Die Haube 6113 ist zwischen zwei Anschlägen eines beweglichen Gehäuseteils 62 beweglich. Die Anschläge 621 und 622 begrenzen also die Beweglichkeit der Haube 6113 gegenüber dem beweglichen Teil 62. Das bewegliche Teil 62 weist zwei federnde Arme 610 auf, die jeweils Bereiche mit Zähnen 611 aufweisen. Diese Zähne 611 greifen in Zahnstangen 69 am ersten Gehäuseteil 61 ein. In Figur 6 befinden sich die Federn 612 und 613 in einem entspannten Zustand. Die Haube 6113 wird gegen den Anschlag 622 des beweglichen Teils 62 gedrückt. Die Feder 612 stützt sich aber am ersten Gehäusteil 61 ab. Der Boden 6131 mit der Metallbrücke wird ebenfalls gegen einen an der Haube 6113 befindlichen Anschlag 6132 gedrückt. Das bewegliche Teil 62 befindet sich in der Stellung, in der es der komplementären Steckerhälfte am nächsten ist. Wird nun eine komplementäre Steckerhälfte 64 beispielsweise mit einer Hebeschraube 6103 eingefügt, so übt die Hebeschraube zunächst einen Druck auf die Haube 6113 aus. Durch diesen Druck wird die Haube 6113 gegen den Anschlag 621 am beweglichen Teil bewegt. Übt die Hebeschraube weiter Druck aus, so bewegt sich die Haube 6113 mit dem beweglichen Teil 62 auf das kabelseitige Ende der Steckerhälfte zu, wie dies in Figur 7 dargestellt ist. Bei dieser Bewegung des beweglichen Gehäuseteils 62 werden die Arme 610 mit den Zähnen 611 über die Zahnstangen 69 am ersten Gehäuseteil 61 verschoben. Wird die zentrale Hebeschraube 6103 nun wieder zurückgedreht und lässt somit der Druck nach, so sorgt die Feder 612 zunächst dafür, dass die Haube 6113 sich mit der Hebeschraube bewegt, bis sie gegen den Anschlag 622 stösst. Entsprechend bewegt sich auch der Boden 6131 bis er gegen den Anschlag 6132 stösst. Durch die beiden Federn 612 und 613 ist es also möglich, ein geringes Spiel der Hebeschraube aufzufangen und trotzdem einen Kontakt zwischen den beiden Kontakten herzustellen. Wird die Hebeschraube weiter herausgedreht, werden die beiden Kontakte 8 nicht mehr kurzgeschlossen und die Anordnung zeigt an, dass die beiden Stecker nicht mehr vollständig miteinander verbunden sind. Da sowohl die Kontaktstifte als auch die Haube federnd ausgebildet sind, findet eine belastungsfreie Kontaktierung nicht nur an einem Punkt, sondern über einen weiten federnden Bereich statt. Dadurch können geringe axiale Toleranzen ausgeglichen werden. Beim ersten Zusammenfügen der beiden Steckerhälften wird jedoch eine grössere Toleranz ausgeglichen, indem das zweite Gehäuseteil gegenüber dem ersten Gehäuseteil von einer ersten Position in eine zweite Position gebracht wird, die für die Zukunft die Ausgangsposition bildet.

## Patentansprüche

1. Anordnung zur elektrischen Überprüfung des Verbindens zweier Teile insbesondere des Steckzustandes zweier Steckerhälften (2) mit folgenden Merkmalen:
- es sind zwei Kontakte (1) vorgesehen, die jeweils einen Bereich (4) zur Kontaktierung eines elektrischen Leiters (10), einen sich daran anschliessenden Zwischenbereich (6) und einen sich an diesen anschliessenden Kontaktstift (5) aufweisen;
- der Kontaktstift (5) ist jeweils in Bezug auf den Zwischenbereich (6) in axialer Richtung federnd verschiebbar;
- es ist ein Gehäuse vorgesehen mit zwei parallelen Kontaktkammern (12) zur Aufnahme der Kontakte (1);
- am Gehäuse (11) ist eine federnd gelagerte Haube (13) vorgesehen, die in Bezug auf die Kontakte (1) in axialer Richtung verschiebbar ist;
- die Haube (13) weist einen Boden (131) auf, der eine Metallbrücke (132) enthält, die die Kontakte (1) kurzschliesst, wenn die Haube (13) eine in entsprechende Stellung verschoben ist.

2. Anordnung nach Anspruch 1, dadurch gekennzeichnet, dass das Gehäuse (11) am ersten zu verbindenden Teil (2) befestigbar ist und die Haube (13) vom zweiten zu verbindenden Teil (3) verschoben wird, wenn die Teile (2,3) verbunden werden.

3. Anordnung nach einem der Ansprüche 1 oder 2, dadurch gekennzeichnet, dass die Haube (13) am Gehäuse (1) unverlierbar angeordnet ist.

4. Anordnung nach einem der Ansprüche 1 bis 3, dadurch gekennzeichnet, dass die Kontakte (1) mit elektrischen Leitern (10) eines Überprüfungsstromkreises verbunden sind.

5. Anordnung nach einem der Ansprüche 1 bis 4, dadurch gekennzeichnet, dass am Gehäuse (1) Mittel zum Verrasten (14) vorgesehen sind.

6. Verwendung einer Anordnung nach einem der Ansprüche 1 bis 5 zur Überprüfung des Steckzustandes zweier Steckerhälften (2,3) wobei das Gehäuse in einer Öffnung der ersten Steckerhälfte (2) für eine zentrale Hebeschraube (3) verrastet ist und die Haube (13) mittels der zentralen Hebeschraube (3) betätigt wird.

7. Kontakte insbesondere zur Verwendung in einer Anordnung zur elektrischen Überprüfung des Verbindens zweier Teile nach einem der Ansprüche 1 bis 5, insbesondere zur Überprüfung des Steckzustandes zweier Steckerhälften mit folgenden Merkmalen:
- es ist ein Bereich (4) zur Kontaktierung eines elektrischen Leiters (10), ein sich daran anschliessender Zwischenbereich (6) und ein sich an diesen anschliessender Kontaktstift (5) vorgesehen,
- der Kontaktstift (5), ist in Bezug auf den Zwischenbereich (6) in axialer Richtung federnd verschiebbar angebracht.

8. Kontakt nach Anspruch 7, dadurch gekennzeichnet, dass im Zwischenbereich (6) ein Aussengehäuse (7) fixiert ist, das eine Feder (8) enthält und in das der Kontaktstift (5) unter Komprimierung der Feder (8) einschiebbar ist.

9. Kontakt nach einem der Ansprüche 7 oder 8, dadurch gekennzeichnet, dass im Zwischenbereich (6) eine Verriegelungsblattfeder (9) zur Verriegelung des Kontaktes in einem Gehäuse (11) vorgesehen ist.

10. Kontakt nach einem der Ansprüche 7 bis 9, dadurch gekennzeichnet, dass der Bereich (4) zur Kontaktierung eines elektrischen Leiters (10) als Crimpbereich ausgebildet ist.

11. Kontakt nach Anspruch 10, dadurch gekennzeichnet, dass der Crimpbereich (4) einen Isolationscrimp (41) und einen Leitercrimp (42) umfasst.

12. Steckerhälfte mit mindestens einer Kontaktkammer (67) für einen elektrischen Kontakt (8) mit einem ersten Gehäuseteil (61) und einem zweiten beweglichen Gehäuseteil (62), das in Richtung auf das kabelseitige Ende der Steckerhälfte hin beweglich ist, wobei die Gehäuseteil (61,62) mittels komplementärer Mittel (65,66) miteinander verrasten, derart, dass das zweite Gehäuseteil mittels der zur Steckerhälfte (63) komplementären Steckerhälfte (64) beim ersten Fügevorgang der Steckerhälften (63,64) von einer ersten Position in eine zweite Position gebracht wird und in dieser zweiten Position verbleibt, wenn die Steckerhälften (63,64) wieder getrennt werden.

13. Steckerhälfte nach Anspruch 12, dadurch gekennzeichnet, dass das erste Gehäuseteil (61) mindestens eine Zahnstange (69) und das bewegliche Gehäuseteil (62) mindestens einen federnden Arm (610) mit Zähnen (611) aufweist, die in die Zahnstange (69) eingreifen, und ein Verschieben des beweglichen Teils (62) zwischen zwei Endpositionen in Richtung auf das kabelseitige Ende der Steckerhälfte hin ermöglichen.

14. Steckerhälfte nach Anspruch 13, dadurch gekennzeichnet, dass die Zähne (611) und die Zahnstange (69) derart ausgebildet sind, dass ein Verschieben in der Richtung zum steckgesichtseitigen Ende des Steckers hin verhindert ist.

15. Steckerhälfte nach einem der Ansprüche 12 bis 14, dadurch gekennzeichnet, dass im ersten Gehäuseteil (61) zwei Kontaktkammern (67) vorgesehen sind, zur Aufnahme jeweils eines elektrischen Kontaktes (8), dass die Kontakte (8) jeweils einen Bereich (4) zur Kontaktierung eines elektrischen Leiters (10), einen sich daran anschliessenden Zwischenbereich (6) und einen sich an diesen anschliessenden Kontaktstift (5) aufweisen, dass der Kontaktstift (5) in Bezug auf den Zwischenbereich (6) in axialer Richtung federnd verschiebbar ist, dass eine federnd gelagerte Haube (6113) vorgesehen ist, die in Bezug auf die Kontakte (8) in axialer Richtung verschiebbar ist, dass die Haube (6113) einen Boden (6131) aufweist, der eine Metallbrücke enthält, die die Kontakte (8) kurzschliesst, wenn die Haube (6113) in eine entsprechende Stellung verschoben ist, und dass der Verschiebeweg der Haube (6113) durch das zweite bewegliche Gehäuseteil (62) festgelegt ist, das auch einen Anschlag für die Haube (6113) bildet.

16. Steckerhälfte nach Anspruch 15, dadurch gekennzeichnet, dass die Haube (6113) derart angeordnet ist, dass sie von der zweiten komplementären Steckerhälfte (63) zwischen zwei Anschlägen am zweiten beweglichen Gehäuseteil (62) verschiebbar ist und mittels einer Feder (612) gegen das erste Gehäuseteil (61) gelagert ist.

17. Anordnung nach einem der Ansprüche 15 oder 16, dadurch gekennzeichnet, dass der Boden (6131) mit der Metallbrücke bezüglich der Haube (6113) in und entgegen der Steckrichtung zwischen zwei Anschlägen an der Haube (6113) beweglich gelagert ist und eine Feder (613) zwischen der Haube (6113) und dem Boden (6131) mit der Metallbrücke vorgesehen ist.
